# EUROPEAN PATENT SPECIFICATION

(11) **EP 1 868 236 B1**
(45) Date of publication and mention of the grant of the patent: **29.07.2009**
(21) Application number: 07011777.5
(22) Date of filing: 15.06.2007
(51) Int. Cl.: H01L 21/677, B65G 37/02

(54) **Overhead traveling vehicle system and transportation method using the same**
Hängefahrzeugsystem und Transportverfahren damit
Système de pont roulant et procédé de transport l'utilisant

(30) Priority: 16.06.2006 JP 2006167384
(43) Date of publication of application: 19.12.2007
(73) Proprietor: MURATA KIKAI KABUSHIKI KAISHA, Minami-ku Kyoto-shi Kyoto 601-8326 (JP)
(72) Inventor: Izumi, Takanori, Inuyama-shi Aichi 484-8502 (JP)
(74) Representative: Wagner, Karl H.

(56) References cited:
- EP-A- 1 547 943
- US-A- 5 571 325
- US-A1- 2006 016 720

## Description

### Technical Field

The present invention relates to an overhead traveling vehicle system. In particular, the present invention relates to a technique of providing additional buffers.

### Background Art

Techniques of providing buffers on sides and below travel rails for overhead traveling vehicles are known (Japanese Laid-Open Patent Publication No. 2005-206371). The inventor studied to further increase the number of buffers, and achieved the present invention.

### Disclosure of the Invention

### Problems to be solved by the Invention

An object of the present invention is to increase the number of buffers where articles can be transferred to and from overhead traveling vehicles.
Another object of the present invention is to reduce the cost of providing a buffer below a travel rail in an upper layer.
Still another object of the present invention is to reduce the cost of providing buffers on sides of respective travel rails in upper and lower layers.

### Means for Solving the Problems

According to an aspect of the present invention, an overhead traveling vehicle system comprising travel rails, an overhead traveling vehicle which travels along the travel rails, buffers along the travel rails at positions where the overhead traveling vehicle can transfer an article to and from the buffers, the travel rails being at least in upper and lower two layers, and means for allowing the overhead traveling vehicle to move between the upper and lower travel rails are provided, and the buffer is provided along each of the upper and lower rails, according to claim 1.
A transportation method according to another aspect of the present invention comprises the steps of:
a) providing the travel rails at least in upper and lower two layers, and providing an elevation path for allowing the overhead traveling vehicle to move between the upper and lower travel rails;
b) moving the overhead traveling vehicle up and down for allowing the overhead traveling vehicle to travel along the travel rails in the upper and lower two layers;
c) transferring the article during transportation between the overhead traveling vehicle and the buffers provided along the travel rails in the upper and lower two layers; and
d) transporting the article from a loading port to an unloading port by the steps of b) and c), according to claim 5.

Preferably, the buffer is provided below the travel rail in the upper layer, and the travel rail in the lower layer and the buffer below the travel rail in the upper layer are supported by a common support member.
Further, preferably, the buffer below the travel rail in the upper layer is provided on an upper surface of the travel rail in the lower layer. The meaning of the buffer provided on an upper surface of the travel rail herein includes a case where the upper surface of the travel rail itself is used as a buffer, and a case in which a buffer is attached to the upper surface of the travel rail.
The buffer below the travel rail will be also referred to as the under buffer.

Further, preferably, the buffer is provided on each of a side of the travel rail in the upper layer and a side of the travel rail of in the lower layer, and the buffer on the side of the travel rail in the upper layer and the buffer on the side of the travel rail in the lower layer are supported by a common support member. Hereinafter, the buffer on the side of the travel rail will be also referred to as the side buffer.

### Advantages of the Invention

In the present invention, since buffers are provided along respective travel rails in upper and lower two layers, it is possible to increase the number of buffers. Since the overhead traveling vehicle can travel between the travel rails in the upper and lower two layers, the buffers in any of the upper and lower layers can be utilized. Therefore, as a whole, improvement in the transportation efficiency in the overhead traveling vehicle system and the buffering capacity for the articles is achieved.

In the case where the travel rail in the lower layer and the buffer below the travel rail in the upper layer are supported by a common support member, it is possible to reduce the cost of providing the buffer. In particular, in the case where the buffer is provided on the upper surface of the lower travel rail, it is possible further reduce the cost of providing the buffer.

In the case where buffers are provided on each of a side of the travel rail in the upper layer and a side of the travel rail in the lower layer, and the buffer on the side of the travel rail in the upper layer and the buffer on the side of the travel rail in the lower layer are supported by a common support member, it is possible to reduce the cost of providing the side buffers.

### Brief Description of the Drawings

[FIG. 1] FIG. 1 is a perspective view schematically showing upper and lower travel rails in an overhead traveling vehicle system according to an embodiment.
[FIG. 2] FIG. 2 is a front view showing main components of the overhead traveling vehicle system according to the embodiment.
[FIG. 3] FIG. 3 is a plan view showing the main components of the overhead traveling vehicle system according to the embodiment.
[FIG. 4] FIG. 4 is a front view showing main components of an overhead traveling vehicle system according to a modified embodiment.
[FIG. 5] FIG. 5 is a front view showing main components of an overhead traveling vehicle system according to a second modified embodiment.

### Description of the numerals

2: overhead traveling vehicle system
4: upper layer travel route
6: lower layer travel route
7, 8: elevation path
10: merge section
12: branch section
14: load port
15: processing equipment
20: upper layer travel rail
21: lower layer travel rail
22, 23: arm
24, 25, 30: support column
26, 27, 52: under buffer
28, 29: side buffer
32: overhead traveling vehicle
34: lateral movement unit
36: elevation drive unit
38: elevation frame
40: article
42, 43: arm
44: pin
46, 48: side buffer

### EMBODIMENT

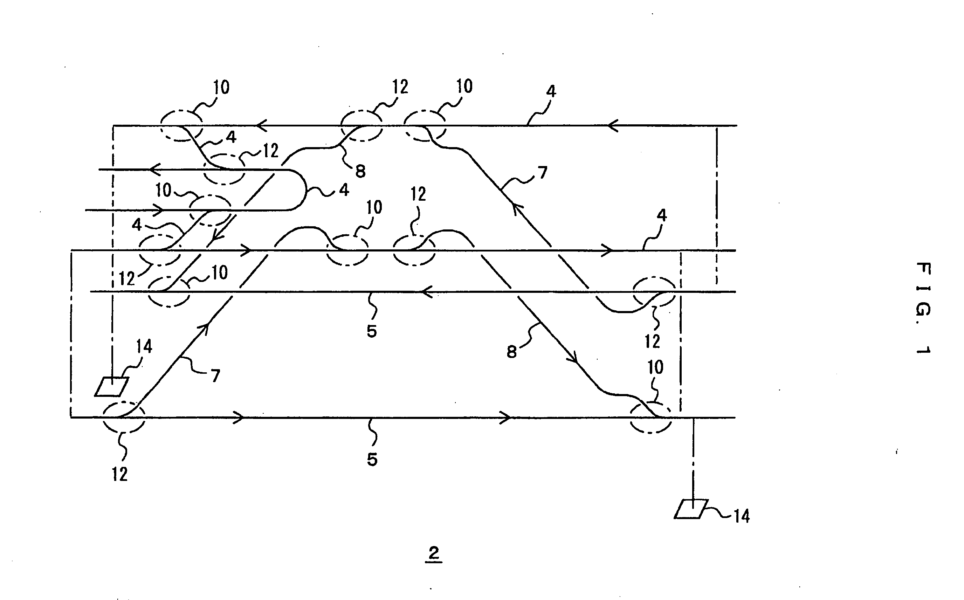

FIGS. 1 to 5 shows an overhead traveling vehicle system 2 according to an embodiment and its modified embodiments. FIG. 1 schematically shows positions of upper and lower travel routes. For example, the overhead traveling vehicle system 2 is provided in a clean room. The height from the floor surface to the ceiling surface is, e.g., 4 meters or more. Upper layer travel routes 4 and lower layer travel routes 6 are provided at different height positions from the floor surface. For example, the upper layer travel routes 4 and the lower layer travel routes 6 are arranged, e.g., in two layers. Although the travel routes 4, 6 are arranged in two layers (upper and lower layers) in the embodiment, the travel routes may be arranged in three or more layers, e.g., upper, middle, and lower layers. The travel routes 4, 6 are connected by elevation paths 7 and 8. The elevation paths 7 are elevation paths from the lower layer travel routes 6 to the upper layer travel routes 4. The elevation paths 8 are elevation paths from the upper layer travel routes 4 to the lower layer travel routes 6. Overhead traveling vehicles elevate and lower along the elevation paths 7, 8 in an auto-guided manner. Instead of the elevation paths 7, 8, elevators having travel rails for overhead traveling vehicles may be provided for allowing the overhead traveling vehicles to move into/out of the elevators along the travel rails, and connecting the upper and lower travel routes 4, 6. Reference numerals 10 denote merge sections, and reference numerals 12 denote branch sections. For example, load ports 14 for processing equipment (not shown) are provided at positions where articles can be transferred to and from the lower layer travel routes 6. Though not shown in FIG. 1, under buffers are provided below the upper and lower layer travel routes 4, 6, and side buffers are provided on sides of the travel routes 4, 6 for buffering the articles.

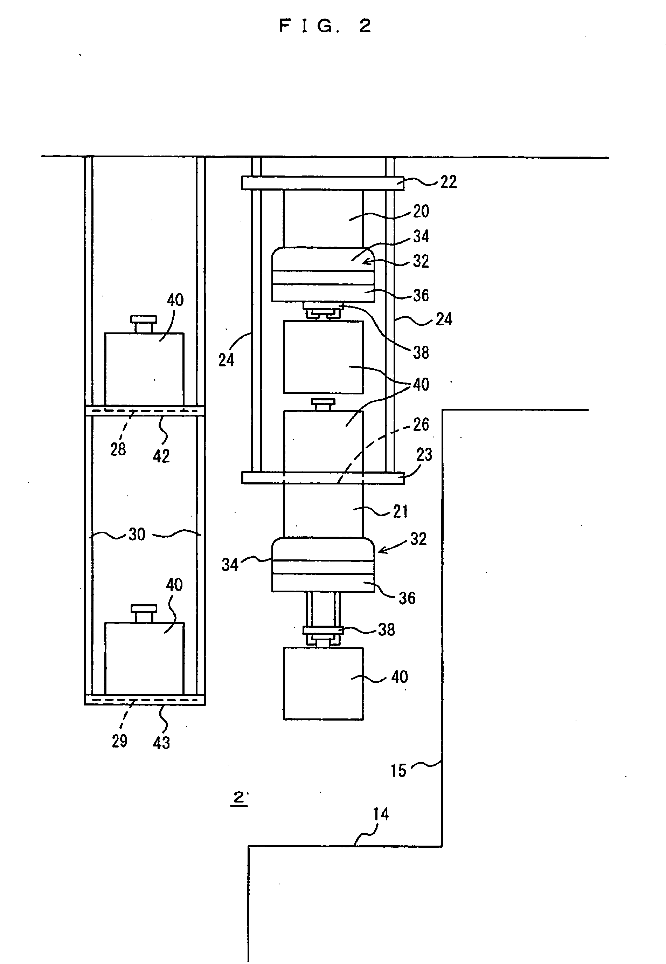

FIG. 2 shows an upper layer travel rail 20 and a lower layer travel rail 21 near the load port 14. The upper layer travel rail 20 is part of the upper layer travel route. The lower layer travel rail 21 is part of the lower layer travel route. Reference numerals 22, 23 are arms for supporting the travel rails 20, 21, and reference numerals 24 denote support columns of the support arms 22, 23. The upper surface of the lower layer travel rail 21 is used as an under buffer 26 below the upper layer travel rail 20. Reference numerals 28, 29 denote side buffers. Articles 40 can be transferred between the side buffer 28 and overhead traveling vehicles traveling along the upper layer travel rail 20. Further, articles 40 can be transferred between the side buffer 29 and overhead traveling vehicles traveling along the lower layer travel rail 21. Reference numerals 30 denote support columns as common support members for the side buffers 28, 29. A reference numeral 42 denotes an arm for connecting the side buffer 28 and the support columns 30, and a reference numeral 43 denotes an arm for connecting the side buffer 29 and the support columns 30.

The overhead traveling vehicles 32 have travel units (not shown) inside the travel rails 20, 21. Reference numerals 34 denote lateral movement units, and reference numerals 36 denote elevation drive units for elevating/lowering elevation frames 38, respectively. The elevation frame 38 is capable of chucking/releasing the article 40. The lateral movement unit 34 laterally moves the elevation drive unit 36, the elevation frame 38, and the article 40 for making it possible to transfer the article 40 to and from the side buffers 28, 29.

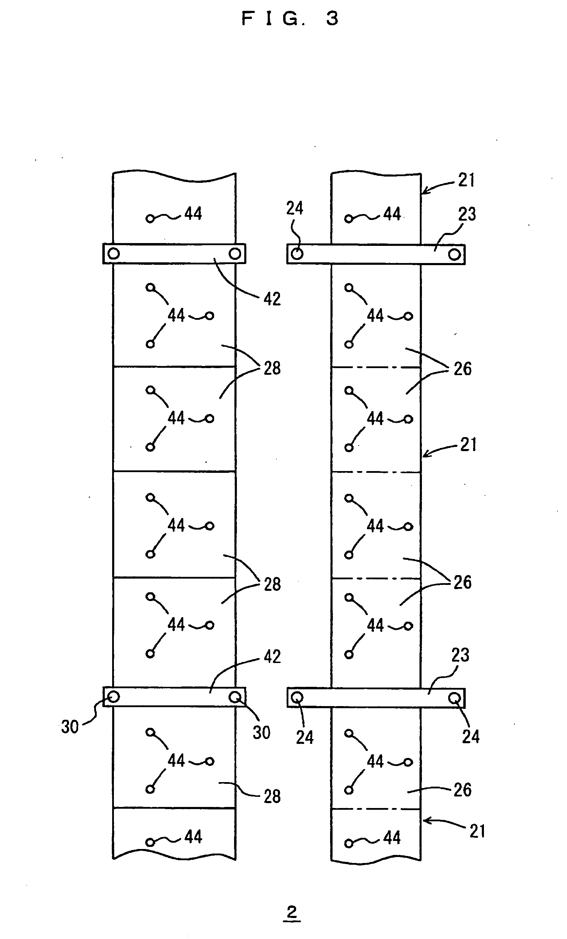

FIG. 3 shows upper surfaces of the side buffers 28 and the under buffers 26. The under buffers 26 are provided on the upper surface of the travel rail 21. Reference numerals 44 denote pins for positioning the bottom of the article. The pins 44 or the like required for the buffer are attached to the travel rail 21. The side buffers 28, 29 are made up of plates or frames having the pins 44 or the like. In addition to positioning members such as the pins 44, for example, the buffers 26, 28, 29 have reflection plates or the like for allowing the overhead traveling vehicle 32 to detect IDs of the buffers such as barcodes or RFIDs, and the presence of articles on the buffers.

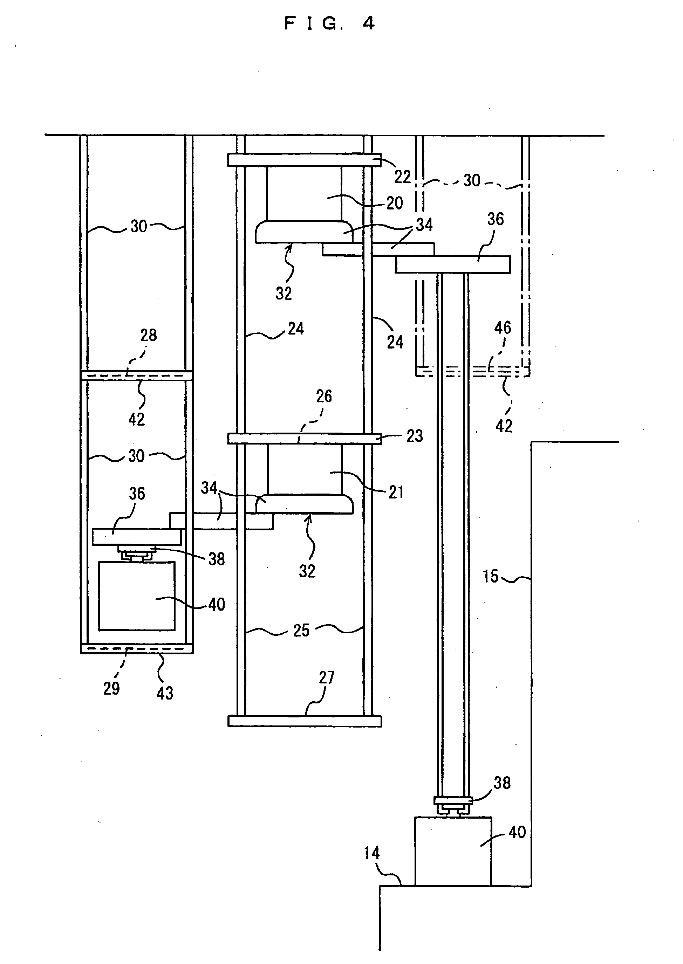

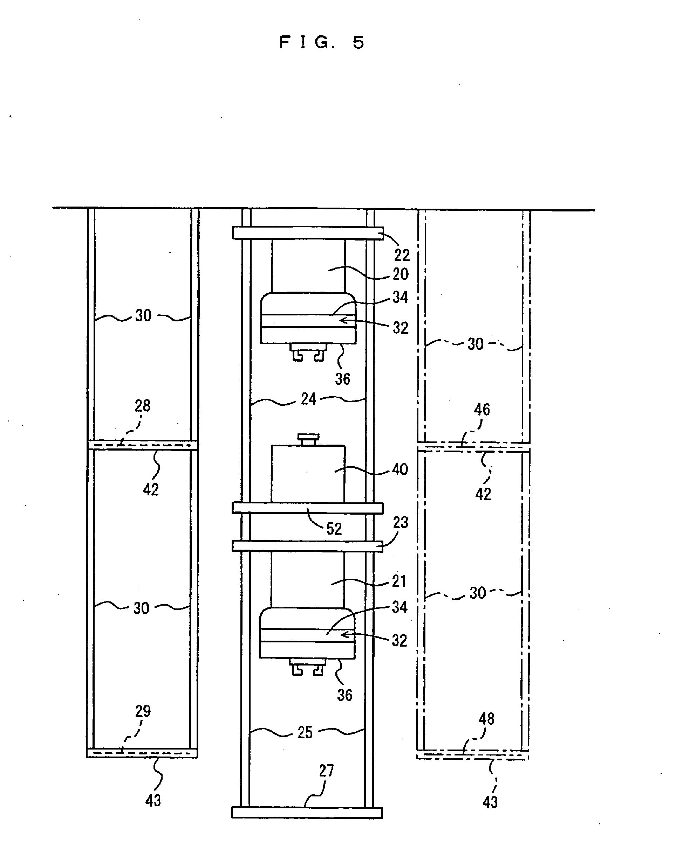

Operation of the embodiment will be described. In the case of transferring the article to and from the load port 14, as shown in FIG. 2, the overhead traveling vehicle 32 travels along the lower layer travel rail 21. The elevation drive unit 36 elevates/lowers the elevation frame 38. In this case, the overhead traveling vehicle traveling along the upper travel rail 20 cannot transfer the article to and from the load port 14. Therefore, the upper layer travel rail 20 is used for bypassing the travel route, and the lower layer travel rail 21 is used for transferring the article to and from the load port 14. The side buffer 28 and the under buffer 26 are provided for the upper layer travel rail 20, and the side buffer 29 is provided for the lower layer travel rail 21. In the area where no load port 14 is provided, an under buffer 27 as shown in FIGS. 4 and 5 is provided.

The article loaded at the load port 14 or the article scheduled to be unloaded to the load port 14 is temporarily stored in the side buffer 29 or the under buffer below the lower layer travel rail 21. The article scheduled to be transported to a remote position is temporality stored in the side buffer 28 or the under buffer 26 as a connecting (relay) point. Further, since the travel rails 20, 21 are connected by the elevation paths 7, 8, the overhead traveling vehicle 32 can travel along both of the travel routes 20, 21. As a result, the number of travel routes available to the overhead traveling vehicles is increased. In the presence of the bypass route comprising the upper layer travel route 4, the occurrence of congestion is minimized. Further, since the number of the overhead traveling vehicles 32 which can be operated in the system is doubled, improvement in the transportation efficiency is achieved. Since the buffers 26, 28, 29, or the like are provided for both of the upper layer travel rail 20 and the lower layer travel rail 21, the number of the buffers is also doubled. As a result, the article scheduled to be transported to the processing equipment 15 can be transported to a buffer near the load port 14 for the processing equipment 15 beforehand, and when the load port 14 becomes empty, the article can be transported to the load port 14 promptly. Further, even if the load port at the next destination is not available, by storing the article in the buffer, it is possible to transport the article from the load port promptly. Since the overhead traveling vehicle 32 can move between the upper layer travel route 4 and the lower layer travel route 6, it is possible to use the buffers in both of the upper and lower layers.

In the embodiment, since the additional under buffers 26 are provided on the upper surface of the lower layer travel rail 21, the cost of providing the under buffers 26 is very small. Specifically, it is sufficient that the plates or the frames each having the pins 44 are attached to the upper surface of the travel rail 21. Further, since the side buffers 28, 29 are positioned in the upper and lower layers in a vertically overlapping manner, and supported by the common support columns, the space occupied by the side buffers 28, 29 as viewed in a horizontal direction is small, and the cost of providing the side buffers 28, 29 is small.

FIG. 4 is a modified embodiment in a case where the overhead traveling vehicle 32 can laterally move the elevation drive unit 36 to both of the right side and the left side. In this case, from either of the upper layer travel rail 20 or the lower layer travel rail 21, the overhead traveling vehicle 32 can laterally move the elevation drive unit 36 for transferring the article 40 to and from the load port 14. In this manner, the space below the lower layer travel rail 21 can be used for providing under buffers. For this purpose, support columns 25 extending downwardly from the support columns 24 are provided to support the under buffer 27. In the area where no load port 14 is provided, as shown by dotted broken line on the right side in FIG. 4, support columns 30 are provided to additionally support the side buffer 46 for the upper layer travel rail 20. If the processing equipment 15 is not positioned under the support columns 30, the support columns 30 may be extended further downwardly for providing a further additional side buffer for the lower layer travel rail 21. The features of the modified embodiment other than those specifically noted above are the same as those of the embodiment shown FIGS. 1 to 3.

FIG. 5 shows a second modified embodiment. Also in this modified embodiment, the overhead traveling vehicle 32 moves the elevation drive unit 36 to both of the left and right sides by the lateral movement unit 34. In the modified embodiment, using the support columns 24, an under buffer 52 is provided at a position slightly above the arm 23. The under buffer 52 may be supported by the travel rail 21. Further, the under buffer 27 is provided below the lower layer travel rail 21. If there is no positional interference with the processing equipment (not shown) or the like, the support columns 30 may be provided also on the other side of the travel rails 20, 21 where the processing equipment is provided, to support side buffers 46, 48 in the upper and lower two layers by the support columns 30 and arms 42, 43.

In the embodiment, the following advantages are obtained.
(1) The travel routes 4, 6 are provided in upper and lower two layers, and the overhead traveling vehicle 32 can use both of the travel routes 4, 6 through the elevation paths 7, 8. Thus, improvement in the efficiency for transporting the articles 40 is achieved.
(2) Since the side buffers 28, 29, the under buffers 26, 27 or the like are provided for both of the travel routes 4, 6 in the upper and lower two layers, it is possible to increase the number of buffers.
(3) The lower layer travel route 6 is used for transfer of the articles to and from the load port 14, and the side buffer 29 and the under buffer 27 below the travel route 6 can be used for transfer of the articles to and from the load port 14. The upper layer travel route 4 can be used as a bypass path or a detour path, and the side buffer 28 and the under buffer 26 can be used as connecting points for long distance transportation of the articles.
(4) The under buffers 26, 27, 52 can be provided using the lower layer travel rails 21, or using the support columns 24 of the lower layer travel rail 21. Therefore, the cost of providing the under buffers 26, 27, 52 is small.
(5) The upper and lower side buffers 28, 29 can be provided using the common support columns 30 in the same space. Therefore, the side buffers 28, 29 can be provided easily, and the cost of providing the side buffers 28, 29 is small.

Although the embodiment has been described in connection with the case in which the travel rails 20, 21 are provided at upper and lower positions in a vertically overlapping manner, it is not necessary to provide the travel rails 20, 21 at upper and lower positions in all of the areas. For example, in an area where traffic of the overhead traveling vehicles is light, only one travel rail may be provided in the upper layer or the lower layer. Further, in the case where the lateral movement unit 34 of the overhead traveling vehicle 32 can move the elevation drive unit 36 to only one side, the upper layer travel rail 20 and the lower layer travel rail 21 may be provided at different positions partially, in a plan view.

## Claims

1. An overhead traveling vehicle system (2) comprising travel rails,
an overhead traveling vehicle traveling along the travel rails,
buffers provided along the travel rails at positions where the overhead traveling vehicle may transfer an article to and from the buffers, and **characterized in that** it further comprises
means for allowing the overhead traveling vehicle to move between upper (20) and lower (21) travel rails;
the travel rails being provided at least in upper and lower two layers; and
the buffer (26,27) being provided along each of the upper and lower rails.

2. The overhead traveling vehicle system according to claim 1, the buffer being provided below the travel rail in the upper layer, and the travel rail in the lower layer and the buffer below the travel rail in the upper layer being supported by a common support member.

3. The overhead traveling vehicle system according to claim 1, wherein, the buffer below the travel rail in the upper layer is provided on an upper surface of the travel rail in the lower layer.

4. The overhead traveling vehicle system according to claim 1, the buffers being provided on each of a side of the travel rail in the upper layer and a side of the travel rail of in the lower layer, and the buffer on the side of the travel rail in the upper layer and the buffer on the side of the travel rail in the lower layer being supported by a common support member.

5. A transportation method carried out by temporarily storing an article during transportation in buffers, the buffers being provided along travel rails for an overhead traveling vehicle, at positions where the overhead traveling vehicle may transfer the article to and from the buffers, the method comprising the steps of:
a) providing the travel rails at least in upper and lower two layers,
an elevation path for allowing the overhead traveling vehicle to move between the upper (20) and lower (21) travel rails, and
the buffers (26,27) along each of the upper and lower travel rails;
b) moving the overhead traveling vehicle up and down for allowing the overhead traveling vehicle to travel along the travel rails in the upper and lower two layers;
c) transferring the article during transportation between the overhead traveling vehicle and the buffers provided along the travel rails in the upper and lower two layers; and
d) transporting the article from a loading port to an unloading port by the steps of b) and c).

## Patentansprüche

1. Ein Hängefahrzeug-Laufsystem (2), welches Folgendes aufweist:
Laufschienen,
ein Hängelauffahrzeug welches entlang der Laufschienen läuft,
Puffer, vorgesehen entlang der Laufschienen an Positionen, wo das Hängelauffahrzeug ein Gegenstand zu den Puffern hin übertragen oder von den Puffern weg übertragen kann, und **dadurch gekennzeichnet, dass** ferner Mittel vorgesehen sind, um zu gestatten, dass sich das Hängelauffahrzeug zwischen den oberen (20) und unteren (21) Laufschienen bewegen kann,
wobei die Laufschienen an mindestens zwei oberen und unteren Schichten vorgesehen sind; und
wobei ferner der Puffer (26, 27) entlang jeder der oberen und unteren Schienen vorgesehen ist.

2. Das Hängefahrzeug-Laufsystem nach Anspruch 1, wobei der Puffer unterhalb der Laufschiene in der oberen Schicht vorgesehen ist und wobei die Laufschiene in der unteren Schicht und der Puffer unterhalb der Laufschiene der oberen Schicht durch ein gemeinsames Tragglied getragen werden.

3. Das Hängefahrzeug-Laufsystem nach Anspruch 1, wobei der Puffer unterhalb der Laufschiene in der oberen Schicht auf einer oberen Oberfläche oder Oberseite der Laufschiene in der unteren Schicht vorgesehen ist.

4. Das Hängefahrzeug-Laufsystem nach Anspruch 1, wobei die Puffer auf jeder Seite der Laufschiene in der oberen Schicht und einer Seite der Laufschiene der unteren Schicht vorgesehen sind, und wobei der Puffer auf der Seite der Laufschiene in der oberen Schicht und der Puffer auf der Seite der Laufschiene in der unteren Schicht durch ein gemeinsames Tragglied getragen werden.

5. Transportverfahren, ausgeführt durch temporäres Speichern eines Gegenstandes während des Transports in Puffern, wobei die Puffer entlang von Laufschienen für ein Hängelauffahrzeug vorgesehen sind, und zwar an Positionen wo das Hängelauffahrzeug den Gegenstand zu den Puffern hin und von diesen Puffern weg übertragen kann, wobei das Verfahren die folgenden Schritte vorsieht:
a) Vorsehen der Laufschienen mindestens in zwei oberen und unteren Schichten,
eines angehobenen Pfades um zu gestatten, dass das Hängelauffahrzeug sich zwischen den oberen (20) und unteren (21) Laufschienen bewegen kann, und
wobei die Puffer (26, 27) entlang der oberen und unteren Laufschienen angeordnet sind;
b) Bewegen des Hängelauffahrzeugs auf und ab um zu gestatten, dass das Hängelauffahrzeug entlang der Laufschienen in den oberen und unteren zwei Schichten laufen kann;
c) Transferieren eines Gegenstandes während des Transports zwischen dem Hängelauffahrzeug und den Puffern, vorgesehen entlang der Laufschienen in den oberen und unteren zwei Schichten; und
d) Transport des Gegenstandes von einem Ladeplatz zu einem Entladeplatz durch die Schritte b) und c).

## Revendications

1. Système de pont roulant (2) comprenant des rails de déplacement,
un pont roulant se déplaçant le long des rails de déplacement,
des tampons prévus le long des rails de déplacement à des positions dans lesquelles le pont roulant peut transférer un article vers les tampons et à partir des tampons, et **caractérisé en ce qu'**il comprend en outre
des moyens pour permettre le déplacement du pont roulant entre des rails de déplacement supérieur (20) et inférieur (21) ;
les rails de déplacement étant prévus au moins dans deux couches supérieure et inférieure ; et
le tampon (26, 27) étant prévu le long de chacun des rails supérieur et inférieur.

2. Système de pont roulant selon la revendication 1, dans lequel le tampon est prévu en dessous du rail de déplacement dans la couche supérieure, et le rail de déplacement dans la couche inférieure et le tampon situé en dessous du rail de déplacement dans la couche supérieure sont supportés par un élément de support commun.

3. Système de pont roulant selon la revendication 1, dans lequel le tampon situé en dessous du rail de déplacement dans la couche supérieure est prévu sur une surface supérieure du rail de déplacement dans la couche inférieure.

4. Système de pont roulant selon la revendication 1, dans lequel les tampons sont prévus d'un côté du rail de déplacement dans la couche supérieure et d'un côté du rail de déplacement dans la couche inférieure, et le tampon situé sur le côté du rail de déplacement dans la couche supérieure et le tampon situé sur le côté du rail de déplacement dans la couche inférieure sont supportés par un élément de support commun.

5. Procédé de transport réalisé en stockant temporairement un article pendant le transport dans des tampons, les tampons étant prévus le long de rails de déplacement pour un pont roulant, à des positions dans lesquelles le pont roulant peut transférer l'article vers les tampons et à partir des tampons, le procédé comprenant les étapes suivantes :
a) prévoir les rails de déplacement au moins dans deux couches supérieure et inférieure,
un trajet d'élévation pour permettre le déplacement du pont roulant entre les rails de déplacement supérieur (20) et inférieur (21), et
les tampons (26, 27) le long de chacun des rails de déplacement supérieur et inférieur ;
b) déplacer le pont roulant vers le haut et vers le bas pour permettre au pont roulant de se déplacer le long des rails de déplacement dans les deux couches supérieure et inférieure ;
c) transférer l'article pendant le transport entre le pont roulant et les tampons prévus le long des rails de déplacement dans les deux couches supérieure et inférieure ; et
d) transporter l'article à partir d'un accès de chargement vers un accès de déchargement par les étapes b) et c) .
